# EUROPÄISCHE PATENTSCHRIFT

(11) **EP 3 245 527 B1**
(45) Veröffentlichungstag und Bekanntmachung des Hinweises auf die Patenterteilung: **03.02.2021**
(21) Anmeldenummer: 15810754.0
(22) Anmeldetag: 18.12.2015
(51) Int. Cl.: G01R 31/62, H02P 13/00

(54) **TRANSFORMATORPRÜFVORRICHTUNG UND VERFAHREN ZUM PRÜFEN EINES TRANSFORMATORS**
TRANSFORMER TESTING DEVICE, AND METHOD FOR TESTING A TRANSFORMER
TESTEUR DE TRANSFORMATEUR ET PROCÉDÉ DE TEST D'UN TRANSFORMATEUR

(30) Priorität: 13.01.2015 AT 500222015
(43) Veröffentlichungstag der Anmeldung: 22.11.2017
(73) Patentinhaber: Omicron electronics GmbH, 6833 Klaus (AT)
(72) Erfinder: FLAX, Dirk, 6850 Dornbirn (AT); PÜTTER, Markus, 6832 Sulz (AT)
(74) Vertreter: Banzer, Hans-Jörg
(86) Internationale Anmeldenummer: PCT/EP2015/080496
(87) Internationale Veröffentlichungsnummer: WO 2016/113072

(56) Entgegenhaltungen:
- WO-A1-2012/155278

## Beschreibung

### GEBIET DER ERFINDUNG

Die Erfindung betrifft eine Transformatorprüfvorrichtung und ein Verfahren zum Prüfen von Transformatoren. Die Erfindung betrifft insbesondere derartige Vorrichtungen und Verfahren, die zur Prüfung eines Dreiphasentransformators eingerichtet sind.

### HINTERGRUND

Transformatoren werden als Bestandteile von Energieversorgungsnetzen verwendet. Transformatoren können zur Spannungswandlung von einem ersten Wert an einer Oberspannungsseite zu einem zweiten Wert, der kleiner als der erste Wert ist, an einer Unterspannungsseite eingesetzt werden.

Die Bestimmung von Eigenschaften Transformators durch eine Transformatorprüfung, bei der eine oder mehrere charakteristische Kenngrößen des Transformators durch Messung ermittelt werden, ist beispielsweise zur Gewährleistung der Betriebssicherheit, zur Ansteuerung oder aus weiteren Gründen erforderlich. Beispiele für derartige Transformatorprüfungen beinhalten die Bestimmung eines statischen Widerstands, die Bestimmung eines dynamischen Widerstands, die Bestimmung eines Übersetzungsverhältnisses und/oder die Bestimmung einer Streuimpedanz oder Streuinduktivität. Bei einer statischen Widerstandsmessung kann ein Gleichstrom in eine Wicklung des Transformators eingespeist werden, und die Spannung kann gemessen werden. Bei einer dynamischen Widerstandsmessung kann das Übersetzungsverhältnis des Transformators mit einem Stufenschalter während der Messung umgeschaltet werden. Eine Spannung, ein Strom und/oder ein Widerstand können erfasst und ausgewertet werden. Aus dem Verlauf der gemessenen Parameter können beispielsweise Rückschlüsse auf einen Zustand des Stufenschalters gezogen werden.

Eine Transformatorprüfvorrichtung kann zur Durchführung von Messungen an einem Dreiphasentransformator eingerichtet sein. Um Flexibilität bei der Durchführung unterschiedlicher Messungen zu erreichen, können herkömmlich Umverdrahtungen vorgenommen werden, die den Arbeits- und Zeitaufwand der Transformatorprüfung erhöhen. Alternativ kann die Transformatorprüfvorrichtung mit einer externen Einheit kombiniert werden, die zwischen die Transformatorprüfvorrichtung und den zu prüfenden Transformator geschaltet wird. Dies birgt jedoch das Risiko fehlerhafter Verbindungen zwischen Transformatorprüfvorrichtung und externer Einheit und führt ebenfalls zu einer Erhöhung des Arbeits- und Zeitaufwands.

Relevanter Stand der Technik wird in WO 2012/155278 A1 offenbart.

### ZUSAMMENFASSUNG DER ERFINDUNG

Es besteht ein Bedarf an Vorrichtungen und Verfahren, mit denen eine Transformatorprüfung in effizienter und flexibler Weise ausgeführt werden kann. Es besteht insbesondere ein Bedarf an Vorrichtungen und Verfahren, die eine Prüfung eines Dreiphasentransformators erlauben und die zusätzliche Flexibilität im Hinblick auf die Ausgabe von Prüfsignalen bieten.

Nach Ausführungsbeispielen werden eine Transformatorprüfvorrichtung und ein Verfahren zum Prüfen eines Transformators angegeben, bei denen die Transformatorprüfvorrichtung zusätzlich zu mehreren Quellen zum Erzeugen von Prüfsignalen auch eine Schaltmatrix umfasst. Die Schaltmatrix ist steuerbar, um die mehreren Quellen selektiv zu kombinieren.

Die Transformatorprüfvorrichtung kann die Erzeugung einer Reihenschaltung der mehreren Quellen erlauben, um an eine der Phasen des Transformators ein Prüfsignal mit erhöhter Spannungsamplitude auszugeben. Die Transformatorprüfvorrichtung kann die Erzeugung einer Parallelschaltung der mehreren Quellen erlauben, um an eine der Phasen des Transformators ein Prüfsignal mit erhöhter Stromamplitude auszugeben.

Mit einer derartigen Transformatorprüfvorrichtung kann erhöhte Flexibilität bei der Prüfung erreicht werden, da Prüfsignale von unterschiedlichen Quellen in unterschiedlicher Weise mehreren Ausgängen zugewiesen werden können. Es kann eine selektive Erhöhung des Prüfsignals für wenigstens eine der Phasen durch Kombination mehrerer Quellen vorgenommen werden, falls dies beispielsweise im Hinblick auf eine Zielgenauigkeit einer Messung gewünscht ist.

Eine Transformatorprüfvorrichtung nach einem Ausführungsbeispiel wird im unabhängigen Anspruch 1 definiert.

Die Schaltmatrix kann mehrere steuerbare Schaltmittel umfassen. Die steuerbaren Schaltmittel können ein oder mehrere Relais umfassen. Die steuerbaren Schaltmittel können ein oder mehrere Leistungstransistoren umfassen.

Die Transformatorprüfvorrichtung kann eine Steuereinrichtung zum Steuern der Schaltmatrix umfassen, die mit wenigstens einem steuerbaren Schaltmittel der Schaltmatrix verbunden ist.

Die Transformatorprüfvorrichtung kann ein Gehäuse umfassen, wobei die mehreren Quellen und die Schaltmatrix in dem Gehäuse angeordnet sind.

Die Steuereinrichtung kann eingerichtet sein, um die Schaltmatrix so anzusteuern, dass in einem ersten Zustand der Schaltmatrix jeder der mehreren Ausgänge mit jeweils nur einer Quelle leitend verbunden ist, und dass in einem zweiten Zustand der Schaltmatrix wenigstens ein Ausgang der mehreren Ausgänge das von wenigstens zwei unterschiedlichen Quellen erzeugte Prüfsignal empfängt.

Die Steuereinrichtung kann eingerichtet sein, um die Schaltmatrix abhängig von einer an einer Benutzerschnittstelle empfangenen Eingabe zu steuern.

Die Benutzerschnittstelle kann eingerichtet sein, um eine Auswahl zwischen einer simultanen Prüfung von drei Phasen des Transformators und einer Prüfung nur einer Phase des Transformators zu ermöglichen.

Jede Quelle der mehreren Quellen kann eingerichtet sein, um als eine Spannungsquelle zu arbeiten.

Jede Quelle der mehreren Quellen kann eingerichtet sein, um als eine Stromquelle zu arbeiten.

Jede Quelle der mehreren Quellen kann derart steuerbar sein, dass sie wahlweise als Spannungsquelle oder als Stromquelle arbeitet.

Die Quellen können eingerichtet sein, um ein Prüfsignal zu erzeugen, das ein Wechselsignal ist.

Die Quellen können eingerichtet sein, um ein Prüfsignal zu erzeugen, das ein Gleichstromsignal oder ein Gleichspannungssignal ist.

Die Transformatorprüfvorrichtung kann wenigstens einen steuerbaren Schalter umfassen, um wenigstens eine der Phasen des Transformators an einer Oberspannungsseite oder an einer Unterspannungsseite kurzzuschließen. Der steuerbare Schalter kann in die Schaltmatrix integriert sein.

Die Transformatorprüfvorrichtung kann wenigstens drei voneinander verschiedene Quellen umfassen. Die Transformatorprüfvorrichtung kann nur drei voneinander verschiedene Quellen umfassen, um eine voneinander unabhängige Prüfung aller Phasen eines Dreiphasentransformators zu ermöglichen.

Die Transformatorprüfvorrichtung kann eingerichtet sein, um mit einer Oberspannungsseite des Transformators verbunden zu werden, um an wenigstens eine der Phasen das Prüfsignal bereitzustellen.

Die Transformatorprüfvorrichtung kann eingerichtet sein, um mit einer Unterspannungsseite des Transformators verbunden zu werden, um an wenigstens eine der Phasen das Prüfsignal bereitzustellen.

Die Schaltmatrix kann eingerichtet sein, um ohne Umverdrahtung zwischen der Transformatorprüfvorrichtung und dem Transformator die Quellen wahlweise mit der Oberspannungsseite oder der Unterspannungsseite des Transformators zu koppeln.

Die Transformatorprüfvorrichtung kann wenigstens eine Messeinrichtung zum Erfassen einer Prüfantwort des Transformators umfassen. Die Transformatorprüfvorrichtung kann mehrere Messeinrichtungen zum Erfassen Prüfantworten der mehreren Phasen des Transformators umfassen.

Ein System nach einem Ausführungsbeispiel umfasst einen Transformator mit mehreren Phasen und eine Transformatorprüfvorrichtung nach einem Ausführungsbeispiel, die über die Ausgänge lösbar mit den mehreren Phasen des Transformators verbunden ist.

Der Transformator kann ein Dreiphasentransformator sein.

Die Transformatorprüfvorrichtung kann mit einer Oberspannungsseite des Transformators verbunden sein.

Die Transformatorprüfvorrichtung kann mit einer Unterspannungsseite des Transformators verbunden sein.

Ein Verfahren zur Prüfung eines Transformators, der mehrere Phasen aufweist, wird nach einem Ausführungsbeispiel im unabhängigen Anspruch 12 definiert.

Das Verfahren kann mit der Transformatorprüfvorrichtung oder dem System nach einem Ausführungsbeispiel ausgeführt werden

Bei dem Verfahren kann die Schaltmatrix gesteuert werden, um die mehreren Quellen in Serie zu schalten.

Bei dem Verfahren kann die Schaltmatrix gesteuert werden, um die mehreren Quellen parallel zu schalten.

Bei dem Verfahren kann die Transformatorprüfvorrichtung ein Gehäuse umfassen, wobei die mehreren Quellen und die Schaltmatrix in dem Gehäuse angeordnet sind.

Bei dem Verfahren kann eine Steuereinrichtung der Transformatorprüfvorrichtung die Schaltmatrix so ansteuern, dass in einem ersten Zustand der Schaltmatrix jeder der mehreren Ausgänge mit jeweils nur einer Quelle leitend verbunden ist, und dass in einem zweiten Zustand der Schaltmatrix wenigstens ein Ausgang der mehreren Ausgänge das von wenigstens zwei unterschiedlichen Quellen erzeugte Prüfsignal empfängt.

Bei dem Verfahren kann die Steuereinrichtung die Schaltmatrix abhängig von einer an einer Benutzerschnittstelle empfangenen Eingabe zu steuern.

Bei dem Verfahren kann eine Benutzereingabe an der Benutzerschnittstelle empfangen werden, mit der eine Auswahl zwischen einer simultanen Prüfung von drei Phasen des Transformators und einer Prüfung nur einer Phase des Transformators zu getroffen wird.

Bei dem Verfahren kann jede Quelle der mehreren Quellen als eine Spannungsquelle arbeiten.

Bei dem Verfahren kann jede Quelle der mehreren Quellen als eine Stromquelle arbeiten.

Bei dem Verfahren kann jede Quelle der mehreren Quellen so angesteuert werden, dass sie wahlweise als eine Spannungsquelle oder als eine Stromquelle arbeitet.

Das Verfahren kann ein Kurzschließen wenigstens einer der Phasen des Transformators an einer Oberspannungsseite oder an einer Unterspannungsseite mit einem steuerbaren Schalter der Transformatorprüfvorrichtung umfassen. Der steuerbare Schalter kann in die Schaltmatrix integriert sein.

Bei dem Verfahren kann die Transformatorprüfvorrichtung wenigstens drei voneinander verschiedene Quellen umfassen. Die Transformatorprüfvorrichtung kann nur drei voneinander verschiedene Quellen umfassen, um eine voneinander unabhängige Prüfung aller Phasen eines Dreiphasentransformators zu ermöglichen.

Bei dem Verfahren kann die Transformatorprüfvorrichtung mit einer Oberspannungsseite des Transformators verbunden werden.

Bei dem Verfahren kann die Transformatorprüfvorrichtung mit einer Unterspannungsseite des Transformators verbunden werden.

Das Verfahren kann ein Erfassen wenigstens einer Prüfantwort des Transformators mit einer Messeinrichtung der Transformatorprüfvorrichtung umfassen.

Das Verfahren kann ein Erfassen von Prüfantworten der mehreren Phasen des Transformators mit mehreren Messeinrichtungen der Transformatorprüfvorrichtung umfassen.

Bei Transformatorprüfvorrichtungen, Systemen und Verfahren nach Ausführungsbeispielen können mehrere Quellen miteinander kombiniert werden, ohne dass dazu eine separate Einheit zwischen der Transformatorprüfvorrichtungen und dem Transformator vorgesehen werden muss.

Verschiedene Wirkungen können mit Transformatorprüfvorrichtungen, Systemen und Verfahren nach Ausführungsbeispielen erzielt werden. Die für die Prüfung benötigte Zeitdauer kann verringert werden. Insbesondere kann Flexibilität ohne zusätzliche Umverdrahtungen erreicht werden.

Transformatoren mit einer Vielzahl unterschiedlicher Ausgestaltungen werden in der Praxis eingesetzt. Die Eigenschaften der Transformatoren variieren entsprechend. Transformatorprüfvorrichtungen, Systeme und Verfahren nach Ausführungsbeispielen ermöglichen eine große Vielfalt von Transformatoren mit einer Vielzahl unterschiedlicher Ausgestaltungen zu prüfen.

Transformatorprüfvorrichtungen, Systeme und Verfahren nach Ausführungsbeispielen erlauben, die Genauigkeit der Bestimmung von Kenngrößen zu erhöhen, indem Messströme und/oder Messspannungen entsprechend angepasst werden.

Transformatorprüfvorrichtungen, Verfahren und Systeme nach Ausführungsbeispielen erlauben eine weitergehende Automatisierung von Transformatorprüfungen.

### KURZE BESCHREIBUNG DER FIGUREN

Die Erfindung wird nachfolgend unter Bezugnahme auf die Zeichnungen anhand bevorzugter Ausführungsformen näher erläutert. In den Zeichnungen bezeichnen identische Bezugszeichen identische Elemente.
Figur 1 zeigt eine Transformatorprüfvorrichtung nach einem Ausführungsbeispiel.
Figur 2 zeigt ein System mit einer Transformatorprüfvorrichtung nach einem Ausführungsbeispiel.
Figur 3 zeigt eine Transformatorprüfvorrichtung nach einem Ausführungsbeispiel.
Figur 4 zeigt eine Transformatorprüfvorrichtung nach einem Ausführungsbeispiel.
Figur 5 zeigt eine Transformatorprüfvorrichtung nach einem Ausführungsbeispiel.
Figur 6 zeigt ein System mit einer Transformatorprüfvorrichtung nach einem Ausführungsbeispiel.
Figur 7 ist ein Flussdiagramm eines Verfahrens nach einem Ausführungsbeispiel.
Figur 8 ist ein Flussdiagramm eines Verfahrens nach einem Ausführungsbeispiel.

### DETAILLIERTE BESCHREIBUNG VON AUSFÜHRUNGSBEISPIELEN

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Darstellungen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und ihr Zweck dem Fachmann verständlich werden.

In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein.

Nachfolgend werden Vorrichtungen und Verfahren zur Durchführung einer Transformatorprüfung mit einer Transformatorprüfvorrichtung detailliert beschrieben. Der Transformator kann ein Transformator für Hoch- oder Mittelspannungsnetze sein. Der Transformator kann ein in einem Kraftwerk oder Umspannwerk installierter Transformator sein. Die Transformatorprüfvorrichtung kann ein mobiles Gerät sein, das die Durchführung der Transformatorprüfung an dem installierten Transformator erlaubt.

Die Transformatorprüfvorrichtung ist eingerichtet, um mit wenigstens einer Phase und bevorzugt mit mehreren Phasen eines Transformators verbunden zu werden. Wie nachfolgend ausführlicher beschrieben wird, umfasst die Transformatorprüfvorrichtung mehrere Quellen. Eine Schaltmatrix erlaubt, selektiv jede der mehreren Phasen des Transformators mit jeweils einem Prüfsignal zu versehen, wobei die an unterschiedliche Phasen angelegten Prüfsignale von unterschiedlichen Quellen erzeugt werden. Durch Ansteuern der Schaltmatrix können die mehreren Quellen so zusammengeschaltet werden, beispielsweise in einer Reihenschaltung oder Parallelschaltung, dass mehrere Prüfsignale miteinander kombiniert werden können und an eine der Phasen angelegt werden können.

Die Transformatorprüfvorrichtung umfasst eine Schaltmatrix, die mehrere steuerbare Schaltmittel umfassen kann. Die steuerbaren Schaltmittel können jeweils ein Relais oder ein anderer Schalter, der zum Schalten eines Lastkreises unter Kontrolle eines Steuerkreises eingerichtet ist, sein. Die steuerbaren Schaltmittel können jeweils ein Bipolartransistor mit isolierter Gate-Elektrode (IGBT) oder ein Feldeffekttransistor (FET) sein oder können einen IGBT oder einen FET umfassen.

Die Schaltmatrix kann automatisch angesteuert werden. Beispielsweise kann die Schaltmatrix automatisch angesteuert werden, wenn eine Erhöhung einer Amplitude eines Prüfsignals für eine der Phasen gewünscht ist.

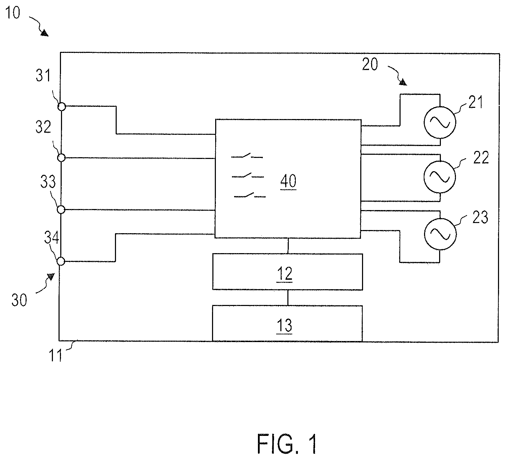

Figur 1 zeigt eine Transformatorprüfvorrichtung 10 nach einem Ausführungsbeispiel. Die Transformatorprüfvorrichtung 10 kann eine Prüfvorrichtung für einen Dreiphasentransformator sein.

Die Transformatorprüfvorrichtung 10 weist ein Gehäuse 11 auf, an dem mehrere Ausgänge 30 vorgesehen sind, um Prüfsignale an unterschiedliche Phasen eines Transformators einzuprägen.

Die Transformatorprüfvorrichtung 10 weist mehrere Quellen 20 auf. Beispielsweise können drei Quellen 21-23 oder mehr als drei Quellen in das Gehäuse 11 integriert sein. Die Quellen 21-23 können voneinander beabstandet in dem Gehäuse 11 angeordnet sein. Eine oder mehrere der Quellen 21-23 kann bzw. können eine Stromquelle sein, die steuerbar ist, um einen Gleichstrom und/oder einen Wechselstrom als Prüfsignal zu erzeugen. Eine oder mehrere der Quellen 21-23 kann bzw. können steuerbar sein, um Wechselströme mit mehreren unterschiedlichen Frequenzen als Prüfsignal zu erzeugen. Eine oder mehrere der Quellen 21-23 kann bzw. können eine Spannungsquelle sein, die steuerbar ist, um eine Gleichspannung und/oder eine Wechselspannung als Prüfsignal zu erzeugen. Eine oder mehrere der Quellen 21-23 kann bzw. können steuerbar sein, um Wechselspannungen mit mehreren unterschiedlichen Frequenzen als Prüfsignal zu erzeugen.

Die Quellen 21-23 können in unterschiedlichen Betriebsmodi betreibbar sein, beispielsweise als Stromquelle oder als Spannungsquelle und/oder als Quelle eines zeitlich konstanten Signals oder eines Wechselsignals.

Die Transformatorprüfvorrichtung 10 umfasst eine Schaltmatrix 40, die zwischen die Quellen 21-23 und die Ausgänge 31-34 geschaltet ist. Wie noch ausführlicher beschrieben wird, ist die Schaltmatrix 40 steuerbar, um Prüfsignale, die von mehreren unterschiedlichen Quellen 21-23 erzeugt werden, zu kombinieren.

Die Schaltmatrix 40 kann so steuerbar sein, dass in einem ersten Zustand, in dem unterschiedliche Phasen eines Transformators parallel geprüft werden können, an jedem von mehreren Ausgängen 31-33 jeweils ein Prüfsignal anliegt, das von nur einer der Quellen 21-23 erzeugt wird. Beispielsweise kann in dem ersten Zustand an einem ersten Ausgang 31 ein von einer ersten Quelle 21 erzeugtes Signal ausgegeben werden. In dem ersten Zustand kann an einem zweiten Ausgang 32 ein von einer zweiten Quelle 22 erzeugtes Signal ausgegeben werden. In dem ersten Zustand kann an einem dritten Ausgang 33 ein von einer dritten Quelle 23 erzeugtes Signal ausgegeben werden. Die Schaltmatrix 40 kann so eingerichtet sein, dass in dem ersten Zustand das Signal jeder der mehreren Quellen 21-23 jeweils nur zu genau einem der Ausgänge 31-33 geführt wird, so dass jeder der Ausgänge 31-33 mit einer anderen der mehreren Quellen 21-23 leitend verbunden ist.

Die Schaltmatrix 40 kann so steuerbar sein, dass in einem zweiten Zustand ein Prüfsignal mit erhöhter Amplitude über wenigstens einen der Ausgänge 31-33 ausgegeben werden kann. In dem zweiten Zustand kann wenigstens ein anderer Ausgang mit keiner der Quellen 21-23 leitend verbunden sein. Beispielsweise kann in dem zweiten Zustand an einem ersten Ausgang 31 ein Signal ausgegeben werden, das durch eine Reihen- oder Parallelschaltung von wenigstens zwei Quellen 21-23 erzeugt wird. In dem zweiten Zustand der Schaltmatrix 40 kann an dem ersten Ausgang 31 ein Signal ausgegeben werden, das durch eine Reihen- oder Parallelschaltung aller Quellen 21-23 erzeugt wird. In dem ersten Zustand kann ein zweiter Ausgang 32 und/oder ein dritter Ausgang 33 durch die Schaltmatrix 40 von jeder der Quellen 21-23 getrennt sein.

Die Transformatorprüfvorrichtung 10 kann weitere Einrichtungen umfassen, beispielsweise eine oder mehrere Messeinrichtungen zum Erfassen einer Prüfantwort als Reaktion auf das Prüfsignal. Die Transformatorprüfvorrichtung 10 kann eine Steuereinrichtung 12 zum automatischen elektrischen Steuern der Schaltmatrix 40 umfassen. Die Steuereinrichtung 12 kann auch zum Steuern der mehreren Quellen 21-23 eingerichtet sein.

Die Transformatorprüfvorrichtung 10 kann eine Auswerteeinrichtung zum Auswerten einer Prüfantwort des Transformators, die mit der Messeinrichtung oder den Messeinrichtungen erfasst wird, umfassen. Die Funktionen der Steuereinrichtung 12 und/oder der Auswerteeinrichtung können von einem Prozessor oder einer anderen integrierten Halbleitschaltung ausgeführt werden.

Die Transformatorprüfvorrichtung 10 kann eine Benutzerschnittstelle 13 umfassen. Die Benutzerschnittstelle 13 kann eine grafische Benutzerschnittstelle sein. Die Benutzerschnittstelle 13 kann dem Benutzer eine Auswahl ermöglichen, die festlegt, ob und ggf. in welcher zeitlichen Abfolge durch die Schaltmatrix 40 mehrere der Quellen 21-23 in einer Reihen- oder Parallelschaltung kombiniert werden.

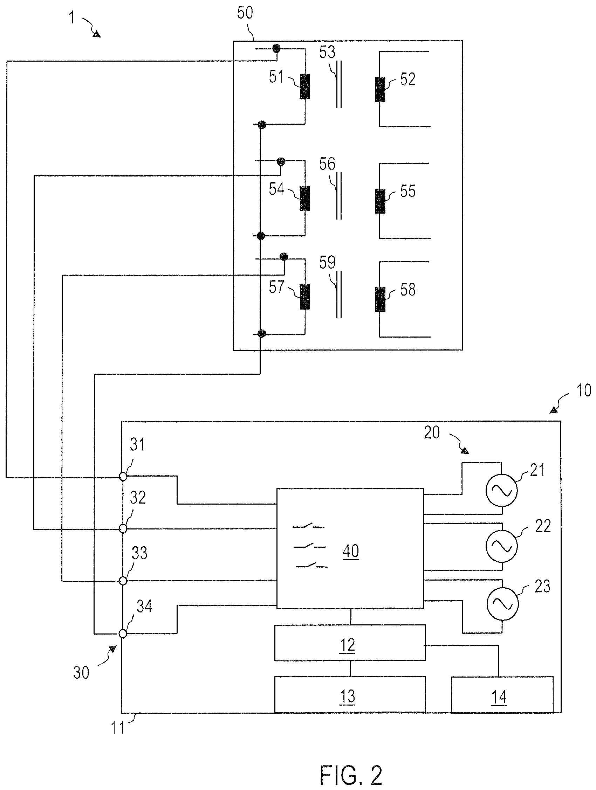

Figur 2 ist eine Darstellung eines Systems 1, das eine Transformatorprüfvorrichtung 10 und einen Transformator 50 umfasst. Der Transformator 50 kann ein Transformator für Hoch- oder Mittelspannungsnetze sein. Der Transformator 50 kann ein in einem Kraftwerk oder Umspannwerk installierter Transformator 50 sein. Die Transformatorprüfvorrichtung 10 kann ein mobiles Gerät sein, das die Durchführung der Transformatorprüfung an dem installierten Transformator 50 erlaubt.

Der Transformator 50 kann ein Dreiphasentransformator sein. Der Transformator weist eine Phase mit einer Wicklung 51 an einer Oberspannungsseite, einer Wicklung 52 an einer Unterspannungsseite und einem Kern 53 auf. Der Transformator weist eine weitere Phase mit einer Wicklung 54 an einer Oberspannungsseite, einer Wicklung 55 an einer Unterspannungsseite und einem Kern 56 auf. Der Transformator kann eine weitere Phase mit einer Wicklung 57 an einer Oberspannungsseite, einer Wicklung 58 an einer Unterspannungsseite und einem Kern 59 aufweisen.

Die Mehrzahl von Anschlüssen 30 der Transformatorprüfvorrichtung 10 ist mit den mehreren Phasen des Transformators 50 verbunden. Beispielsweise kann jeder der Anschlüsse 31-33, über die ein Prüfsignal von der Transformatorprüfvorrichtung ausgegeben werden kann, mit jeweils nur einer der Phasen des Transformators 50 verbunden sein.

Da eine Kombination unterschiedlicher Quellen 21-23 durch die in die Transformatorprüfvorrichtung 10 integrierte Schaltmatrix 40 erfolgen kann, können Leitungen, die an die Ausgänge 31-33 angeschlossen sind, direkt mit dem Transformator verbunden werden. Es ist nicht erforderlich, eine externe Einheit zwischen der Transformatorprüfvorrichtung 10 und dem Transformator 50 vorzusehen.

Die Transformatorprüfvorrichtung 10 weist eine Messeinrichtung 14 oder mehrere Messeinrichtungen 14 auf, die in das Gehäuse 11 integriert sein können. Die Transformatorprüfvorrichtung 10 kann so eingerichtet sein, dass unterschiedliche Messungen erfolgen können, ohne dass die Verbindungen zwischen der Transformatorprüfvorrichtung 10 und dem Transformator 50 gelöst und/oder anders angeschlossen werden müssen. Die unterschiedlichen Messungen können ausgeführt werden, ohne dass der Prüfling umverdrahtet werden muss. Die Messungen können von der Transformatorprüfvorrichtung 10 vollständig oder teilweise automatisiert, d.h. ohne Interaktion des Benutzers zwischen den Messungen, durchgeführt werden.

Die Transformatorprüfvorrichtung 10 kann eingerichtet sein, um eine Messung oder mehrere Messungen an dem Transformator 50 auszuführen, die ausgewählt sind aus der Gruppe bestehend aus einer Kurzschlussimpedanzmessung, einer Wicklungswiderstandsmessung, einer Übersetzungsmessung, einer Demagnetisierungsmessung und/oder einer Streuinduktivitätsmessung.

Beispielsweise kann die Transformatorprüfvorrichtung 10 eine Übersetzungsmessung ausführen. Dazu können die Quellen 21-23 jeweils als Wechselspannungsquelle betrieben werden. Eine Spannung an den Wicklungen 51, 54, 57 kann erfasst werden. Eine Spannung an der Wicklung 52, 55, 58 an der Unterspannungsseite kann beispielsweise mit der Messeinrichtung 14 erfasst werden. Aus einem Verhältnis der Spannungen kann das Übersetzungsverhältnis für jede der Phasen von der Transformatorprüfvorrichtung 10 bestimmt werden.

Die Transformatorprüfvorrichtung 10 kann alternativ oder zusätzlich eingerichtet sein, um eine Kurzschlussimpedanzmessung auszuführen. Dazu können die Quellen 21-23 jeweils als Wechselstromquelle betrieben werden. Ein in die Transformatorprüfvorrichtung 10 integriertes steuerbares Schaltmittel, das in Figur 2 nicht dargestellt ist, kann mit einer der Wicklungen 51, 54, 57 verbunden sein und kann so angesteuert werden, dass die entsprechende Wicklung automatisch kurzgeschlossen wird. Es kann die Wechselspannung erfasst werden, die über der Wicklung abfällt, um die Kurzschlussimpedanz zu ermitteln.

Die Transformatorprüfvorrichtung 10 kann alternativ oder zusätzlich eingerichtet sein, um eine Wicklungswiderstandsmessung auszuführen. Die Widerstandsmessung kann eine statische Widerstandsmessung sein. Es kann der Wicklungswiderstand einer der Wicklungen 51, 54, 57 bestimmt werden. Zur Bestimmung des Wicklungswiderstands können die Quellen 21-23 jeweils als Gleichstromquelle arbeiten. Die Spannung an den Wicklungen 51, 54, 57 kann von der ersten Messeinrichtung 14 gemessen werden. Der Gleichstrom kann eingeprägt werden, bis der Eisenkern 53, 56, 59 der jeweiligen Phase in Sättigung geht, um die Wicklungswiderstandsmessung auszuführen.

Für wenigstens eine oder mehrere der ausgeführten Messungen kann die Transformatorprüfvorrichtung 10 automatisch mehrere der Quellen 21-23 in einer Reihen- oder Parallelschaltung zusammenschalten, um die Größe des eingeprägten Prüfsignals zu erhöhen. Auf diese Weise können genauere Messergebnisse erzielt werden.

Für wenigstens eine weitere der ausgeführten Messungen kann die Transformatorprüfvorrichtung 10 die Schaltmatrix 40 so steuern, dass die Quellen 21-23 nicht in einer Reihen- oder Parallelschaltung zusammengeschaltet werden. Messungen an unterschiedlichen Phasen können zeitlich überlappend und insbesondere gleichzeitig ausgeführt werden, um die gesamte zur Transformatorprüfung benötigte Zeit zu verringern.

Unterschiedliche Techniken können eingesetzt werden, um zu bestimmen, ob die Schaltmatrix 40 so gesteuert werden soll, dass mehrere der Quellen 21-23 in einer Reihen- oder Parallelschaltung zusammengeschaltet werden. Beispielsweise kann die Steuereinrichtung 12 abhängig von einer Sollgenauigkeit der Messung, die automatisch oder benutzerdefiniert vorgebbar ist, bestimmen, ob die mehreren Quellen 21-23 in einer Reihen- oder Parallelschaltung zusammengeschaltet werden. Die entsprechenden Messungen können dann sequentiell an den unterschiedlichen Phasen des Transformators 50 ausgeführt werden. Alternativ oder zusätzlich kann über eine Benutzereingabe an der Benutzerschnittstelle 13 festlegbar sein, ob und ggf. für welche Messungen die mehreren Quellen 21-23 in einer Reihen- oder Parallelschaltung zusammengeschaltet werden. Alternativ oder zusätzlich kann die Steuereinrichtung 12 automatisch abhängig von einer Prüfantwort des Transformators 50 bestimmen, ob eine höhere Amplitude des Prüfsignals erforderlich ist und die die mehreren Quellen 21-23 hierfür in einer Reihen- oder Parallelschaltung zusammengeschaltet werden.

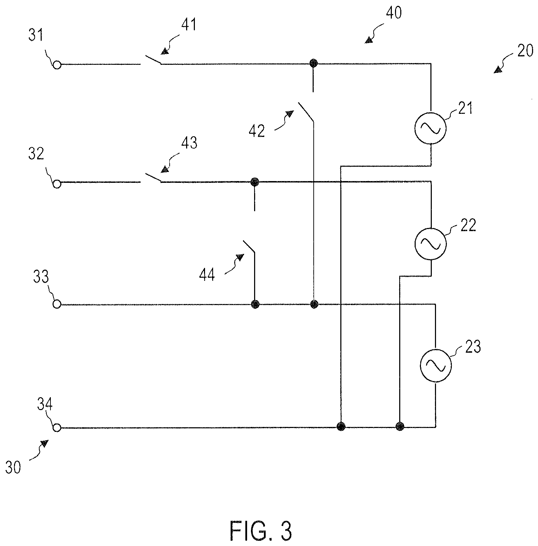

Die Schaltmatrix kann eine Vielfalt unterschiedlicher Ausgestaltungen aufweisen. Exemplarische Ausgestaltungen werden unter Bezugnahme auf Figur 3 bis Figur 5 näher erläutert.

Figur 3 zeigt schematisch die Schaltmatrix 40 einer Transformatorprüfvorrichtung 40 nach einem Ausführungsbeispiel.

Die Schaltmatrix 40 weist eine Mehrzahl steuerbarer Schaltmittel 41-44 auf. Jedes der steuerbaren Schaltmittel 41-44 kann jeweils ein Relais oder ein anderer Schalter, der zum Schalten eines Lastkreises unter Kontrolle eines Steuerkreises eingerichtet ist, sein. Die steuerbaren Schaltmittel können jeweils ein Bipolartransistor mit isolierter Gate-Elektrode (IGBT) oder ein Feldeffekttransistor (FET) sein oder können einen IGBT oder einen FET umfassen.

Ein Ausgang 34 kann als gemeinsamer Anschluss für mehrere Phasen dienen. Der Ausgang 34 kann mit Masse verbunden sein oder kann anderweitig als Stromsenke dienen. Die anderen Ausgänge 31-33 können jeweils mit Wicklungen unterschiedlicher Phasen des Transformators 50 verbunden sein.

Die erste Quelle 21 weist zwei Anschlüsse auf. Ein erster Anschluss der ersten Quelle 21 ist über ein erstes steuerbares Schaltmittel 41 mit dem ersten Ausgang 31 verbunden. Der erste Anschluss der ersten Quelle 21 ist über ein zweites steuerbares Schaltmittel 42 mit dem dritten Ausgang 33 verbunden. Der zweite Anschluss der ersten Quelle 21 ist mit dem Ausgang 34 verbunden.

Die zweite Quelle 22 weist zwei Anschlüsse auf. Ein erster Anschluss der zweiten Quelle 22 ist über ein drittes steuerbares Schaltmittel 43 mit dem zweiten Ausgang 32 verbunden. Der erste Anschluss der zweiten Quelle 22 ist über ein viertes steuerbares Schaltmittel 44 mit dem dritten Ausgang 33 verbunden. Der zweite Anschluss der zweiten Quelle 22 ist mit dem Ausgang 34 verbunden.

Die dritte Quelle 23 weist zwei Anschlüsse auf. Ein erster Anschluss der dritten Quelle 23 ist mit dem dritten Ausgang 33 verbunden. Ein zweiter Anschluss der dritten Quelle 23 ist mit dem Ausgang 34 verbunden.

Die Verwendung der Transformatorprüfvorrichtung mit der Schaltmatrix 40 ist nicht auf den Fall beschränkt, dass der Transformator eine primärseitige Sternschaltung aufweist. Beispielsweise können Verfahren und Vorrichtungen auch eingesetzt werden, wenn die Phasen in einer Delta- oder Dreieckskonfiguration verschaltet sind.

Die Schaltmatrix 40 kann eingerichtet sein, die Quellen selektiv zwischen unterschiedliche Phasen zu schalten. Alternativ oder zusätzlich kann die Schaltmatrix 40 eingerichtet sein, um die Quellen wahlweise an die Primärseite des Transformators oder an die Sekundärseite zu schalten.

Durch Ansteuern des ersten steuerbaren Schaltmittels 41 und des zweiten steuerbaren Schaltmittels 42 kann die erste Quelle 21 selektiv mit der dritten Quelle 23 parallel geschaltet werden. Falls das erste steuerbare Schaltmittel 41 so gesteuert wird, dass es geschlossen ist, und das zweite steuerbare Schaltmittel 42 so gesteuert wird, dass es offen ist, liegt das von der ersten Quelle 21 erzeugte erste Prüfsignal über den ersten Ausgang 31 an einer ersten Phase des Transformators 50 an. Falls das erste steuerbare Schaltmittel 41 so gesteuert wird, dass es offen ist, und das zweite steuerbare Schaltmittel 42 so gesteuert wird, dass es geschlossen ist, wird das von der ersten Quelle 21 erzeugte erste Prüfsignal mit dem von der dritten Quelle 23 erzeugten dritten Prüfsignal und optional mit dem von der zweiten Quelle 22 erzeugten zweiten Prüfsignal kombiniert, um über den dritten Ausgang 33 ein Signal zur Prüfung der dritten Phase des Transformators 50 bereitzustellen.

Durch Ansteuern des dritten steuerbaren Schaltmittels 43 und des zweiten steuerbaren Schaltmittels 42 kann die zweite Quelle 22 selektiv mit der dritten Quelle 23 parallel geschaltet werden. Falls das dritte steuerbare Schaltmittel 43 so gesteuert wird, dass es geschlossen ist, und das vierte steuerbare Schaltmittel 44 so gesteuert wird, dass es offen ist, liegt das von der zweiten Quelle 22 erzeugte zweite Prüfsignal über den zweiten Ausgang 32 an einer zweiten Phase des Transformators 50 an. Falls das dritte steuerbare Schaltmittel 43 so gesteuert wird, dass es offen ist, und das vierte steuerbare Schaltmittel 44 so gesteuert wird, dass es geschlossen ist, wird das von der zweiten Quelle 22 erzeugte zweite Prüfsignal mit dem von der dritten Quelle 23 erzeugten dritten Prüfsignal und optional mit dem von der ersten Quelle 21 erzeugten ersten Prüfsignal kombiniert, um über den dritten Ausgang 33 ein Signal zur Prüfung der dritten Phase des Transformators 50 bereitzustellen.

Durch Ansteuern der steuerbaren Schaltmittel 41-44 können die erste Quelle 21, die zweite Quelle 22 und die dritte Quelle 23 parallel geschaltet werden. Dadurch kann beispielsweise dann, wenn die Quellen 21-23 als Stromquellen betrieben werden, ein Prüfsignal mit höherer Stromamplitude zur Verbesserung der Genauigkeit der Prüfung ausgegeben werden.

Die Schaltmatrix 40 kann weitere steuerbare Schaltmittel umfassen, um zu erlauben, dass das von der Parallelschaltung der ersten Quelle 21, der zweiten Quelle 22 und der dritten Quelle 23 erzeugte Signal wahlweise in jede der unterschiedlichen Phasen des Transformators 50 eingeprägt werden kann.

Die Schaltmatrix 40 kann weitere steuerbare Schaltmittel umfassen, um zu erlauben, dass das von der Parallelschaltung der ersten Quelle 21, der zweiten Quelle 22 und der dritten Quelle 23 erzeugte Signal wahlweise in die Oberspannungsseite oder die Unterspannungsseite des Transformators eingeprägt wird.

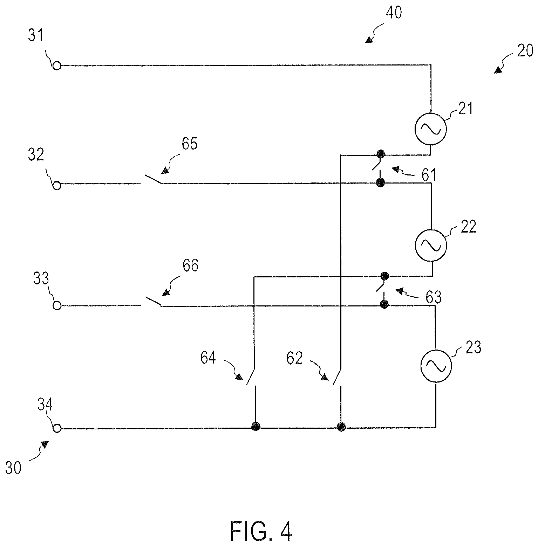

Figur 4 zeigt schematisch die Schaltmatrix 40 einer Transformatorprüfvorrichtung 40 nach einem Ausführungsbeispiel. Die Schaltmatrix 40 ist so ausgestaltet, dass die mehren Quellen 21-23 in Reihe verschaltet werden können.

Die Schaltmatrix 40 weist eine Mehrzahl steuerbarer Schaltmittel 61-66 auf. Jedes der steuerbaren Schaltmittel 61-66 kann jeweils ein Relais oder ein anderer Schalter, der zum Schalten eines Lastkreises unter Kontrolle eines Steuerkreises eingerichtet ist, sein. Die steuerbaren Schaltmittel können jeweils ein Bipolartransistor mit isolierter Gate-Elektrode (IGBT) oder ein Feldeffekttransistor (FET) sein oder können einen IGBT oder einen FET umfassen.

Ein Ausgang 34 dient als gemeinsamer Anschluss für mehrere Phasen, um ein Referenzpotenzial festzulegen. Der Ausgang 34 kann mit Masse oder einem anderen Referenzpotenzial verbunden sein. Die anderen Ausgänge 31-33 können jeweils mit Wicklungen unterschiedlicher Phasen des Transformators 50 verbunden sein.

Die erste Quelle 21 weist zwei Anschlüsse auf. Ein erster Anschluss der ersten Quelle 21 ist mit dem ersten Ausgang 31 verbunden. Der zweite Anschluss der ersten Quelle 21 ist über ein erstes steuerbares Schaltmittel 61 mit einem ersten Anschluss der zweiten Quelle 22 verbunden. Der zweite Anschluss der ersten Quelle 21 ist über ein zweites steuerbares Schaltmittel 62 mit dem Ausgang 34 verbunden.

Die zweite Quelle 22 weist zwei Anschlüsse auf. Ein erster Anschluss der zweiten Quelle 22 ist über ein fünftes steuerbares Schaltmittel 65 mit dem zweiten Ausgang 32 verbunden. Der zweite Anschluss der zweiten Quelle 22 ist über ein drittes steuerbares Schaltmittel 64 mit einem ersten Anschluss der ersten Quelle 21 verbunden. Der zweite Anschluss der zweiten Quelle 22 ist über ein viertes steuerbares Schaltmittel 64 mit dem Ausgang 34 verbunden.

Die dritte Quelle 23 weist zwei Anschlüsse auf. Ein erster Anschluss der dritten Quelle 23 ist über ein sechstes steuerbares Schaltmittel 66 mit dem dritten Ausgang 33 verbunden. Ein zweiter Anschluss der dritten Quelle 23 ist mit dem Ausgang 34 verbunden.

Durch Ansteuern der steuerbaren Schaltmittel 61-65 der Schaltmatrix 40 können zwei oder mehr als zwei Quellen 21-23 selektiv in Reihe verschaltet werden.

Beispielsweise kann die Schaltmatrix 40 derart angesteuert werden, dass das erste Schaltmittel 61 offen ist, das zweite Schaltmittel 62 geschlossen ist, das dritte Schaltmittel 63 offen ist, das vierte Schaltmittel 64 geschlossen ist, das fünfte Schaltmittel 65 geschlossen ist und das sechste Schaltmittel 66 geschlossen ist.

Dadurch kann erreicht werden, dass das erste Prüfsignal der ersten Quelle 21 über den ersten Ausgang 31 an die erste Phase des Transformators bereitgestellt wird, das zweite Prüfsignal der zweiten Quelle 22 über den zweiten Ausgang 32 an die zweite Phase des Transformators bereitgestellt wird und das dritte Prüfsignal der dritten Quelle 23 über den dritten Ausgang 33 an die dritte Phase des Transformators bereitgestellt wird.

Die Schaltmatrix 40 kann derart angesteuert werden, dass das erste Schaltmittel 61 geschlossen ist, das zweite Schaltmittel 62 offen ist, das dritte Schaltmittel 63 offen ist, das vierte Schaltmittel 64 geschlossen ist, das fünfte Schaltmittel 65 offen ist und das sechste Schaltmittel 66 geschlossen ist. Dadurch kann erreicht werden, dass die erste Quelle 21 und die zweite Quelle 22 in Serie geschaltet sind. Ein Signal, das aus Kombination des ersten Prüfsignals der ersten Quelle 21 und des zweiten Prüfsignals der zweiten Quelle 22 gebildet wird, kann an über den ersten Ausgang 31 in die erste Phase des Transformators eingeprägt werden.

Die Schaltmatrix 40 kann derart angesteuert werden, dass das erste Schaltmittel 61 geschlossen ist, das zweite Schaltmittel 62 offen ist, das dritte Schaltmittel 63 geschlossen ist, das vierte Schaltmittel 64 offen ist, das fünfte Schaltmittel 65 offen ist und das sechste Schaltmittel 66 offen ist. Dadurch kann erreicht werden, dass die erste Quelle 21, die zweite Quelle 22 und die dritte Quelle 23 in Serie geschaltet sind. Ein Signal, das aus Kombination des ersten Prüfsignals der ersten Quelle 21, des zweiten Prüfsignals der zweiten Quelle 22 und des dritten Prüfsignals der dritten Quelle 23 gebildet wird, kann an über den ersten Ausgang 31 in die erste Phase des Transformators eingeprägt werden.

Durch Ansteuern der steuerbaren Schaltmittel 61-66 können die erste Quelle 21, die zweite Quelle 22 und die dritte Quelle 23 in Reihe geschaltet werden. Dadurch kann beispielsweise dann, wenn die Quellen 21-23 als Spannungsquellen betrieben werden, ein Prüfsignal mit höherer Spannungsamplitude zur Verbesserung der Genauigkeit der Prüfung ausgegeben werden.

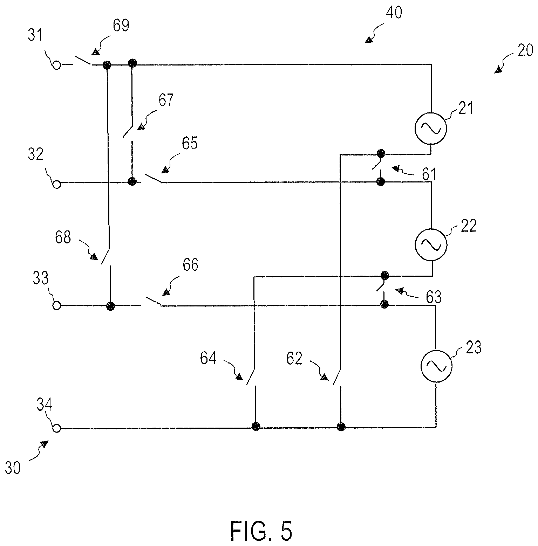

Die Schaltmatrix 40 kann weitere steuerbare Schaltmittel umfassen, um zu erlauben, dass das von der Reihenschaltung der ersten Quelle 21, der zweiten Quelle 22 und der dritten Quelle 23 erzeugte Signal wahlweise in jede der unterschiedlichen Phasen des Transformators 50 eingeprägt werden kann, wie in Figur 5 dargestellt.

Die Verwendung der Transformatorprüfvorrichtung mit der Schaltmatrix 40 ist nicht auf den Fall beschränkt, dass der Transformator eine primärseitige Sternschaltung aufweist. Beispielsweise können Verfahren und Vorrichtungen auch eingesetzt werden, wenn die Phasen in einer Delta- oder Dreieckskonfiguration verschaltet sind.

Die Schaltmatrix 40 kann eingerichtet sein, die Quellen selektiv zwischen unterschiedliche Phasen zu schalten. Alternativ oder zusätzlich kann die Schaltmatrix 40 eingerichtet sein, um die Quellen wahlweise an die Primärseite des Transformators oder an die Sekundärseite zu schalten.

Figur 5 zeigt schematisch die Schaltmatrix 40 einer Transformatorprüfvorrichtung 40 nach einem Ausführungsbeispiel. Die Schaltmatrix 40 ist so ausgestaltet, dass die mehren Quellen 21-23 in Reihe verschaltet werden können. Durch weitere Schaltmittel 67-69 kann das Ausgangssignal der Reihenschaltung der Quellen 21-23 selektiv zu jedem der Ausgänge 31-33 geführt werden.

Die Schaltmatrix 40 weist eine Mehrzahl steuerbarer Schaltmittel 61-66 auf, die wie unter Bezugnahme auf Figur 4 beschrieben ausgestaltet sein können. Darüber hinaus weist die Schaltmatrix 40 ein siebtes steuerbares Schaltmittel 67, ein achtes steuerbares Schaltmittel 68 und ein neuntes steuerbares Schaltmittel 69 auf. Jedes der steuerbaren Schaltmittel 61-69 kann jeweils ein Relais oder ein anderer Schalter, der zum Schalten eines Lastkreises unter Kontrolle eines Steuerkreises eingerichtet ist, sein. Die steuerbaren Schaltmittel können jeweils ein Bipolartransistor mit isolierter Gate-Elektrode (IGBT) oder ein Feldeffekttransistor (FET) sein oder können einen IGBT oder einen FET umfassen.

Eine Reihenschaltung der ersten Quelle 21, der zweiten Quelle 22 und der dritten Quelle 23 kann erzeugt werden, indem beispielsweise die Schaltmatrix 40 derart angesteuert wird, dass das erste Schaltmittel 61 geschlossen ist, das zweite Schaltmittel 62 offen ist, das dritte Schaltmittel 63 geschlossen ist, das vierte Schaltmittel 64 offen ist, das fünfte Schaltmittel 65 offen ist und das sechste Schaltmittel 66 offen ist.

Ist das neunte steuerbare Schaltmittel 69 geschlossen und sind das siebte steuerbare Schaltmittel 67 und das achte steuerbare Schaltmittel 68 offen, wird das Ausgangssignal der Reihenschaltung der Quellen 21-23 über den ersten Ausgang 31 einer ersten Phase des Transformators eingeprägt.

Ist das siebte steuerbare Schaltmittel 67 geschlossen und sind das achte steuerbare Schaltmittel 68 und das neunte steuerbare Schaltmittel 69 offen, wird das Ausgangssignal der Reihenschaltung der Quellen 21-23 über den zweiten Ausgang 32 einer zweiten Phase des Transformators eingeprägt.

Ist das achte steuerbare Schaltmittel 68 geschlossen und sind das siebte steuerbare Schaltmittel 67 und das neunte steuerbare Schaltmittel 69 offen, wird das Ausgangssignal der Reihenschaltung der Quellen 21-23 über den dritten Ausgang 33 einer dritten Phase des Transformators eingeprägt.

Durch Ansteuern der Schaltmatrix 40 kann eine Reihenschaltung der Quellen 21-23 erzeugt werden, deren Ausgangssignal sequentiell jeder der unterschiedlichen Phasen des Transformators zugeführt werden kann.

Eine Vielzahl weiterer Ausgestaltungen der Schaltmatrix 40 ist möglich. Beispielsweise kann die Schaltmatrix 40 steuerbare Schaltmittel 41-44, wie sie unter Bezugnahme auf Figur 3 beschrieben wurden, und steuerbare Schaltmittel 61-66 oder 61-69, wie sie unter Bezugnahme auf Figur 4 und Figur 5 beschrieben wurden, aufweisen, um wahlweise eine Parallel- oder ein Reihenschaltung der Quellen 21-23 zu erzeugen. Dies kann insbesondere dann vorteilhaft sein, wenn die Quellen 21-23 sowohl als Spannungsquellen als auch als Stromquellen betrieben werden können.

Weitere steuerbare Schalter können in die Schaltmatrix 40 integriert oder zusätzlich zu der Schaltmatrix 40 vorgesehen sein. Beispielsweise kann ein oder können mehrere steuerbare Schalter in die Transformatorprüfvorrichtung 10 integriert sein, um Wicklungen an der Oberspannungsseite und/oder der Unterspannungsseite des Transformators 50 kurzzuschließen.

Es kann ein oder können mehrere steuerbare Schalter in die Transformatorprüfvorrichtung 10 integriert sein, um eine oder mehrere Quellen 21-23 oder eine Parallel- oder Serienschaltung von einer oder mehreren Quellen wahlweise mit wenigstens einer Wicklung an der Oberspannungsseite oder wenigstens eine Wicklung an der Unterspannungsseite des Transformators 50 zu verbinden.

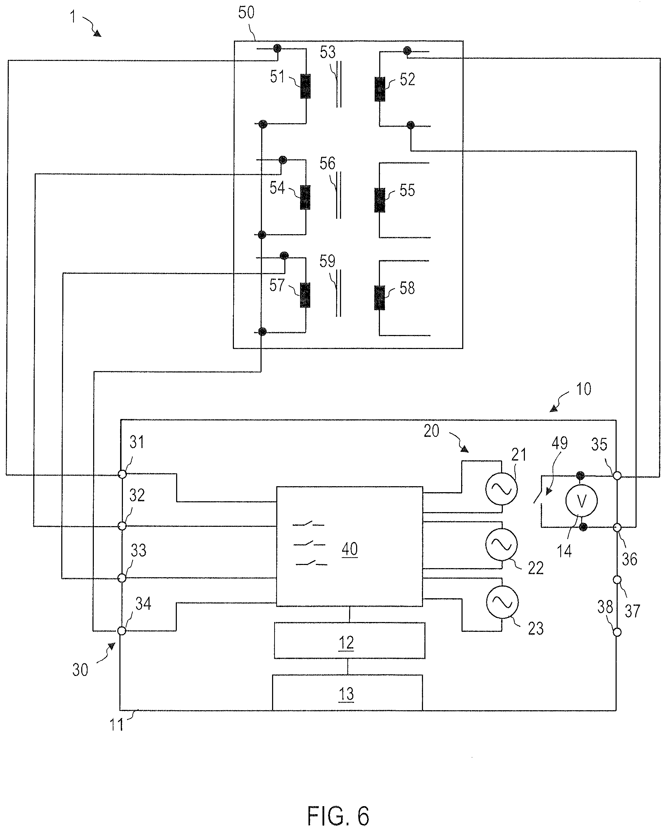

Figur 6 zeigt eine schematische Darstellung eines Systems 1 mit einer Transformatorprüfvorrichtung 10 nach einem Ausführungsbeispiel. Die Transformatorprüfvorrichtung 10 weist Anschlüsse 35-38 auf, die für eine Kopplung mit Wicklungen an der Oberspannungsseite und/oder Unterspannungsseite des Transformators 50 eingerichtet sind.

Ein steuerbarer Schalter 49 kann in die Schaltmatrix 40 integriert oder zusätzlich zu der Schaltmatrix 40 vorgesehen sein. Der steuerbare Schalter 49 ist in dem Gehäuse 11 der Transformatorprüfvorrichtung 10 angeordnet und kann als Kurzschlussschalter ausgestaltet sein. Durch Ansteuerung des steuerbaren Schalters 49 kann wenigstens eine Wicklung des Transformators 50 kurzgeschlossen werden. Der steuerbare Schalter 49 kann zeitabhängig betätigt werden, beispielsweise um nach einem Aufmagnetisieren eines Transformatorkerns die Prüfantwort zu verstärken, die als Reaktion auf ein Prüfsignal erfasst wird.

Auch wenn in Figur 6 beispielhaft nur ein steuerbarer Schalter 49 dargestellt ist, kann die Transformatorprüfvorrichtung 10 mehrere derartige steuerbare Schalter 49 aufweisen, die als Kurzschlussschalter dienen. Ein oder mehrere Kurzschlussschalter können über die Schaltmatrix 40 mit mehreren unterschiedlichen Wicklungen des Transformators verbindbar sein.

Die Transformatorprüfvorrichtung 10 kann unterschiedliche Messeinrichtungen aufweisen, wie Spannungsmesseinrichtungen 14 oder Strommesseinrichtungen.

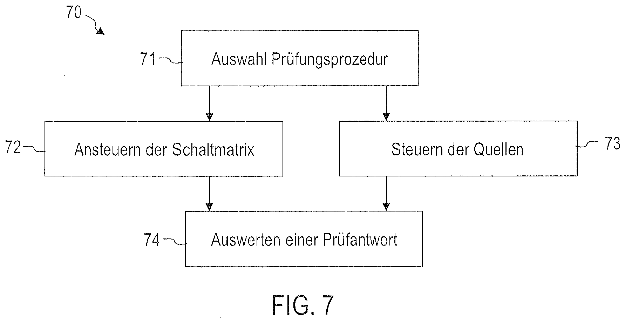

Figur 7 ist ein Flussdiagramm eines Verfahrens 70 nach einem Ausführungsbeispiel. Das Verfahren 70 kann von der Transformatorprüfvorrichtung 10 nach einem Ausführungsbeispiel automatisch ausgeführt werden.

Bei Schritt 71 kann eine Auswahl einer Prüfungsprozedur erfolgen. Die Prüfungsprozedur kann eine oder mehrere Messungen umfassen, die an dem Transformator 50 ausgeführt werden. Die Prüfungsprozedur kann benutzerdefiniert aus einer Mehrzahl von Prüfungsprozeduren ausgewählt werden.

Bei Schritt 72 wird die Schaltmatrix 40 gesteuert. Die Schaltmatrix 40 kann abhängig von der ausgewählten Prüfungsprozedur zeitabhängig gesteuert werden. Die steuerbaren Schaltmittel der Schaltmatrix 40 können automatisch so gesteuert werden, dass zwei, drei oder mehr als drei Quellen der Transformatorprüfvorrichtung 10 während wenigstens eines Teils der Prüfungsprozedur in einer Reihen- oder Serienschaltung kombiniert werden.

Bei Schritt 73 werden die Quellen 21-23 zum Erzeugen des Prüfsignals gesteuert. Die Quellen 21-23 können so gesteuert werden, dass sie wahlweise einen Gleichstrom, eine Gleichspannung oder eine Wechselspannung erzeugt. Es können auch zeitabhängig unterschiedliche Prüfsignale erzeugt werden.

Die Ansteuerung der Quellen 21-23 und die Ansteuerung der Schaltmatrix 40 können zeitlich miteinander koordiniert werden. Beispielsweise kann in einem Teil einer Prüfungsprozedur, in dem die Quellen 21-23 als Stromquellen arbeiten, die Schaltmatrix 40 so gesteuert werden, dass die Quellen 21-23 parallel geschaltet werden. In einem Teil einer Prüfungsprozedur, in dem die Quellen 21-23 als Spannungsquellen arbeiten, kann die Schaltmatrix 40 so gesteuert werden, dass die Quellen 21-23 in Reihe geschaltet werden.

Bei Schritt 74 kann eine Prüfantwort des Transformators 50 automatisch ausgewertet werden. Die Auswertung kann die Bestimmung eines Wicklungswiderstands bei einer statischen Widerstandsmessung, die Bestimmung einer Streuimpedanz, die Bestimmung einer Streuinduktivität, die Bestimmung eines Übersetzungsverhältnisses oder die Bestimmung einer Kombination von zwei oder mehr als zwei dieser Kenngrößen umfassen.

Während der Prüfungsprozedur kann die Schaltmatrix 40 einmal oder mehrfach geschaltet werden.

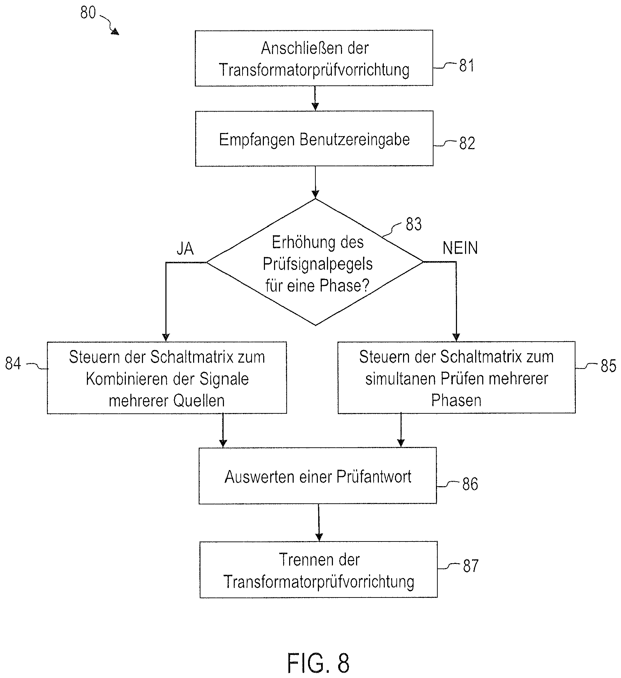

Figur 8 ist ein Flussdiagramm eines Verfahrens 80 nach einem Ausführungsbeispiel. Das Verfahren 80 kann zur Prüfung eines Transformators, der einen Stufenschalter umfasst, von der Transformatorprüfvorrichtung 10 automatisch ausgeführt werden.

Bei Schritt 81 wird die Transformatorprüfvorrichtung 10 lösbar mit dem Transformator 50 verbunden.

Bei Schritt 82 kann eine Benutzereingabe von der Transformatorprüfvorrichtung 10 empfangen werden. Die Benutzereingabe kann eine Prüfungsprozedur auswählen. Die Benutzereingabe kann festlegen, ob wenigstens während eines Teils der Prüfungsprozedur mehrere Quellen 21-23 der Transformatorprüfvorrichtung 10 in einer Reihen- oder Parallelschaltung kombiniert werden.

Bei Schritt 83 kann überprüft werden, ob ein Pegel eines Prüfsignals, das an eine der mehreren Phasen des Transformators angelegt wird, selektiv erhöht werden soll. Die Überprüfung kann abhängig von der bei Schritt 81 empfangenen Benutzereingabe erfolgen. Die Überprüfung kann zusätzlich oder alternativ abhängig von einer Prüfantwort des Transformators 50 erfolgen. Falls beispielsweise die abhängig von der Prüfantwort erzielte Messgenauigkeit einer Messgrößer eine Sollgenauigkeit nicht erreicht, die benutzerdefiniert vorgebbar sein kann, kann die Transformatorprüfvorrichtung 10 erkennen, dass der Pegel des Prüfsignals erhöht werden soll, indem zwei, drei oder mehr Quellen 21-23 in Reihe oder parallel verschaltet werden. Falls der Pegel erhöht werden soll, kann das Verfahren bei Schritt 84 fortgesetzt werden. Andernfalls kann das Verfahren bei Schritt 85 fortgesetzt werden.

Bei Schritt 84 kann die Schaltmatrix 40 so gesteuert werden, dass zwei, drei oder mehr Quellen 21-23 der Transformatorprüfvorrichtung in Reihe oder parallel geschaltet werden. Das Prüfsignal mit erhöhtem Pegel kann sequentiell an Wicklungen unterschiedlicher Phasen des Transformators angelegt werden.

Bei Schritt 85 kann die Schaltmatrix 40 so gesteuert werden, dass Wicklungen mehrerer Phasen des Transformators zeitlich überlappend jeweils ein Prüfsignal zugeführt wird.

Bei Schritt 86 kann eine Prüfantwort ausgewertet werden. Die Auswertung der Prüfantwort kann die Bestimmung eines Wicklungswiderstands bei einer statischen Widerstandsmessung, die Bestimmung einer Streuimpedanz, die Bestimmung einer Streuinduktivität, die Bestimmung eines Übersetzungsverhältnisses oder die Bestimmung einer Kombination von zwei oder mehr als zwei dieser Kenngrößen umfassen.

Bei Schritt 87 kann die Transformatorprüfvorrichtung von dem Transformator abgetrennt werden. Es kann eine automatische weitere Auswertung und/oder Archivierung der Ergebnisse der Transformatorprüfung durch die Transformatorprüfvorrichtung erfolgen.

Während Ausführungsbeispiele unter Bezugnahme auf die Figuren detailliert beschrieben wurden, können bei weiteren Ausführungsbeispielen alternative oder zusätzliche Merkmale verwendet werde. Während beispielsweise die Verwendung einer Transformatorprüfvorrichtung in Kombination mit einem Dreiphasentransformator beschrieben wurde, können die Vorrichtungen und Verfahren nach Ausführungsbeispielen auch für Transformatoren mit einer anderen Anzahl von Phasen verwendet werden.

Bei den Vorrichtungen, Systemen und Verfahren können die Quellen unterschiedliche Prüfsignale erzeugen. Beispielsweise kann eine der Quellen als Spannungsquelle betrieben werden, während eine andere der Quellen gleichzeitig als Stromquelle betrieben wird.

Während bei Ausführungsbeispielen eine Prüfungsprozedur, die die Bestimmung einer oder mehrerer Kenngrößen des Transformators beinhaltet, automatisch ausgeführt werden kann, können die Transformatorprüfvorrichtung und das Verfahren nach Ausführungsbeispielen auch verwendet werden, wenn nur eine Kenngröße des Transformators gemessen wird, bevor eine neue Benutzereingabe erforderlich ist.

Während der Transformator in einem Kraftwerk oder Umspannwerk eines Energieversorgungsnetzes installiert sein kann, können die Transformatorprüfvorrichtung und das Verfahren nach Ausführungsbeispielen auch bei kleineren Transformatoren eingesetzt werden.

Verschiedene Wirkungen können mit Transformatorprüfvorrichtungen, Systemen und Verfahren nach Ausführungsbeispielen erzielt werden. Die für die Prüfung benötigte Zeitdauer kann verringert werden. Insbesondere kann Flexibilität ohne zusätzliche Umverdrahtungen erreicht werden. Transformatoren mit einer Vielzahl unterschiedlicher Ausgestaltungen werden in der Praxis eingesetzt. Die Eigenschaften der Transformatoren variieren entsprechend. Transformatorprüfvorrichtungen, Systeme und Verfahren nach Ausführungsbeispielen ermöglichen eine große Vielfalt von Transformatoren mit einer Vielzahl unterschiedlicher Ausgestaltungen zu prüfen. Transformatorprüfvorrichtungen, Systeme und Verfahren nach Ausführungsbeispielen erlauben auch, die Genauigkeit der Bestimmung von Kenngrößen zu erhöhen, indem Messströme und/oder Messspannungen entsprechend angepasst werden. Beispielsweise können durch die Schaltmatrix Prüfsignale in ihrer Amplitude selektiv erhöht werden.

Transformatorprüfvorrichtung, Verfahren und Systeme nach Ausführungsbeispielen bieten erhöhte Flexibilität bei einer teilweise oder vollständig automatisierten Transformatorprüfung.

## Patentansprüche

1. Transformatorprüfvorrichtung, umfassend
ein Gehäuse (11) mit mehreren Ausgängen (31-33) zur lösbaren Verbindung der Transformatorprüfvorrichtung mit Wicklungen mehreren Phasen eines Transformators (50) und zum Ausgeben von Prüfsignalen an die mehreren Phasen des Transformators (50),
mehrere in das Gehäuse (11) integrierte Quellen (21-23), wobei jede Quelle (21-23) der mehreren Quellen (21-23) jeweils zum Erzeugen eines Prüfsignals eingerichtet ist, und
eine Schaltmatrix (40), die zwischen die mehreren Quellen (21-23) und die Ausgänge (31-33) geschaltet ist, wobei die Schaltmatrix (40) steuerbar ist, um wenigstens zwei Quellen der mehreren Quellen (21-23) in Serie oder parallel zu schalten und an wenigstens einem Ausgang der mehreren Ausgänge (31-33) ein Signal als Prüfsignal auszugeben, das durch die Serienschaltung oder die Parallelschaltung der wenigstens zwei Quellen erzeugt wird.

2. Transformatorprüfvorrichtung nach Anspruch 1, umfassend
eine Steuereinrichtung (12) zum Steuern der Schaltmatrix (40), die mit wenigstens einem steuerbaren Schaltmittel (41-44; 61-66; 61-69) der Schaltmatrix (40) verbunden ist.

3. Transformatorprüfvorrichtung nach Anspruch 2,
wobei die Steuereinrichtung (12) eingerichtet ist, um die Schaltmatrix (40) so anzusteuern, dass in einem ersten Zustand der Schaltmatrix (40) jeder der mehreren Ausgänge (31-33) mit jeweils nur einer Quelle (21-23) leitend verbunden ist, und dass in einem zweiten Zustand der Schaltmatrix (40) wenigstens ein Ausgang (31 - 33) der mehreren Ausgänge mit wenigstens zwei unterschiedlichen Quellen (21-23) verbunden ist.

4. Transformatorprüfvorrichtung nach Anspruch 2 oder Anspruch 3,
wobei die Steuereinrichtung (12) eingerichtet ist, um die Schaltmatrix (40) abhängig von einer an einer Benutzerschnittstelle (13) empfangenen Eingabe zu steuern.

5. Transformatorprüfvorrichtung nach Anspruch 4,
wobei die Benutzerschnittstelle (13) eingerichtet ist, um eine Auswahl zwischen einer simultanen Prüfung von den mehreren Phasen des Transformators (50) und einer Prüfung nur einer Phase des Transformators (50) zu ermöglichen.

6. Transformatorprüfvorrichtung nach einem der vorhergehenden Ansprüche, wobei jede Quelle (21-23) der mehreren Quellen (21-23) eingerichtet ist, um als eine Spannungsquelle zu arbeiten.

7. Transformatorprüfvorrichtung nach einem der vorhergehenden Ansprüche, wobei jede Quelle (21-23) der mehreren Quellen (21-23) eingerichtet ist, um als eine Stromquelle zu arbeiten.

8. Transformatorprüfvorrichtung nach einem der vorhergehenden Ansprüche, wobei jede Quelle (21-23) der mehreren Quellen (21-23) so steuerbar ist, dass sie wahlweise als Spannungsquelle oder als Stromquelle arbeitet.

9. Transformatorprüfvorrichtung nach einem der vorhergehenden Ansprüche, wobei die Transformatorprüfvorrichtung (10) wenigstens einen steuerbaren Schalter (49) umfasst, um wenigstens eine der Phasen des Transformators (50) an einer Oberspannungsseite oder an einer Unterspannungsseite kurzzuschließen.

10. Transformatorprüfvorrichtung nach einem der vorhergehenden Ansprüche, wobei die Transformatorprüfvorrichtung (10) wenigstens drei voneinander verschiedene Quellen (21-23) umfasst.

11. System, umfassend
einen Transformator (50) mit mehreren Phasen und
eine Transformatorprüfvorrichtung (10) nach einem der Ansprüche 1 bis 10, die über die Ausgänge (31-33) der Transformatorprüfvorrichtung (10) lösbar mit den mehreren Phasen des Transformators (50) verbunden ist.

12. Verfahren zum Prüfen eines Transformators (50), der mehrere Phasen aufweist, mit einer Transformatorprüfvorrichtung (10),
wobei die Transformatorprüfvorrichtung (10) mehrere Ausgänge (31-33) zur lösbaren Verbindung der Transformatorprüfvorrichtung (10) mit Wicklungen der mehrere Phasen des Transformators (50) aufweist,
wobei das Verfahren umfasst:
Steuern mehrerer Quellen (21-23) der Transformatorprüfvorrichtung (10) jeweils zum Erzeugen eines Prüfsignals, und
Steuern einer Schaltmatrix (40) der Transformatorprüfvorrichtung (10), um wenigstens einen Ausgang der mehreren Ausgänge (31-33) der Transformatorprüfvorrichtung selektiv mit einer Serienschaltung oder einer Parallelschaltung von wenigstens zwei Quellen der mehreren Quellen (21-23) zu verbinden und an dem wenigstens einen Ausgang ein Signal als Prüfsignal auszugeben, das durch die Serienschaltung oder die Parallelschaltung der wenigstens zwei Quellen erzeugt wird.

13. Verfahren nach Anspruch 12,
das mit der Transformatorprüfvorrichtung (10) nach einem der Ansprüche 1 bis 10 ausgeführt wird.

## Claims

1. A transformer testing device, comprising
a housing (11) having a plurality of outputs (31-33) for releasably connecting the transformer testing device to windings of a plurality of phases of a transformer (50) and for outputting test signals to the plurality of phases of the transformer (50),
a plurality of sources (21-23) integrated in the housing (11), wherein each source (21-23) of the plurality of sources (21-23) is configured in each case for generating a test signal, and
a switching matrix (40) connected between the plurality of sources (21-23) and the outputs (31-33), wherein the switching matrix (40) is controllable to connect at least two sources of the plurality of sources (21-23) in series or in parallel and to output at at least one output of the plurality of outputs (31-33) a signal as a test signal generated by the at least two sources being connected in series or in parallel.

2. The transformer testing device according to claim 1, comprising
a control device (12) for controlling the switching matrix (40), which is connected to at least one controllable switching means (41-44; 61-66; 61-69) of the switching matrix (40).

3. The transformer testing device according to claim 2,
wherein the control device (12) is configured to control the switching matrix (40) such that, in a first state of the switching matrix (40), each of the plurality of outputs (31-33) is conductively connected to respectively only one source (21-23), and that, in a second state of the switching matrix (40), at least one output (31-33) of the plurality of outputs is connected to at least two different sources (21-23).

4. The transformer testing device according to claim 2 or claim 3,
wherein the control device (12) is configured to control the switching matrix (40) depending on an input received at a user interface (13).

5. The transformer testing device according to claim 4,
wherein the user interface (13) is configured to enable a selection between a simultaneous test of the plurality of phases of the transformer (50) and a test of only one phase of the transformer (50).

6. The transformer testing device according to any one of the preceding claims, wherein each source (21-23) of the plurality of sources (21-23) is configured to operate as a voltage source.

7. The transformer testing device according to any one of the preceding claims, wherein each source (21-23) of the plurality of sources (21-23) is configured to operate as a current source.

8. The transformer testing device according to any one of the preceding claims, wherein each source (21-23) of the plurality of sources (21-23) is controllable such that it operates optionally as a voltage source or as a current source.

9. The transformer testing device according to any one of the preceding claims, wherein the transformer testing device (10) comprises at least one controllable switch (49) to short-circuit at least one of the phases of the transformer (50) at a high-voltage side or at a low-voltage side.

10. The transformer testing device according to any one of the preceding claims, wherein the transformer testing device (10) comprises at least three sources (21-23) which are different from each other.

11. A system comprising
a transformer (50) having a plurality of phases, and
a transformer testing device (10) according to any one of claims 1 to 10, which is releasably connected to the plurality of phases of the transformer (50) via the outputs (31-33) of the transformer testing device (10).

12. A method for testing a transformer (50) having a plurality of phases with a transformer testing device (10),
the transformer testing device (10) comprising a plurality of outputs (31-33) for releasably connecting the transformer testing device (10) to windings of the plurality of phases of the transformer (50),
wherein the method comprises:
controlling a plurality of sources (21-23) of the transformer testing device (10) in each case for generating a test signal, and
controlling a switching matrix (40) of the transformer testing device (10) to conductively connect at least one output of the plurality of outputs (31-33) of the transformer testing device selectively to a series connection or a parallel connection of at least two sources of the plurality of the sources (21-23) and to output at the at least one output a signal as a test signal which is generated by the series connection or the parallel connection of the at least two sources.

13. The method according to claim 12,
which is performed with the transformer testing device (10) according to any one of claims 1 to 10.

## Revendications

1. Dispositif testeur de transformateur, comprenant
un boîtier (11) à plusieurs sorties (31-33) pour une connexion amovible du dispositif testeur de transformateur avec des enroulements de multiples phases d'un transformateur (50) et pour délivrer en sortie des signaux de test vers les multiples phases du transformateur (50),
des multiples sources (21-23) intégrées dans le boîtier (11), dans lequel chaque source (21-23) des multiples sources (21-23) est configurée respectivement pour générer un signal de test, et
une matrice de commutation (40) qui est commutée entre les multiples sources (21-23) et les sorties (31-33), dans lequel la matrice de commutation (40) peut être commandée pour commuter au moins deux sources des multiples sources (21-23) en série ou en parallèle et pour délivrer en sortie un signal en tant que signal de test au niveau d'au moins une sortie des multiples sorties (31-33), qui est généré par la commutation en série ou la commutation en parallèle des au moins deux sources.

2. Dispositif testeur de transformateur selon la revendication 1, comprenant
un appareil de commande (12) pour commander la matrice de commutation (40), qui est connecté à au moins un moyen de commutation pouvant être commandé (41-44; 61-66; 61-69) de la matrice de commutation (40).

3. Dispositif testeur de transformateur selon la revendication 2,
dans lequel l'appareil de commande (12) est configuré pour commander la matrice de commutation (40), de telle sorte que dans un premier état de la matrice de commutation (40), chacune des multiples sorties (31-33) est connectée de manière conductrice à respectivement seulement une source (21-23), et que dans un second état de la matrice de commutation (40), au moins une sortie (31-33) des multiples sorties est connectée à au moins deux sources (21-23) différentes.

4. Dispositif testeur de transformateur selon la revendication 2 ou la revendication 3,
dans lequel l'appareil de commande (12) est configuré pour commander la matrice de commutation (40) en fonction d'une entrée reçue au niveau d'une interface utilisateur (13).

5. Dispositif testeur de transformateur selon la revendication 4,
dans lequel l'interface utilisateur (13) est configurée pour permettre un choix entre un test simultané des multiples phases du transformateur (50) et un test de seulement une phase du transformateur (50).

6. Dispositif testeur de transformateur selon l'une quelconque des revendications précédentes,
dans lequel chaque source (21-23) des multiples sources (21-23) est configurée pour fonctionner comme une source de tension.

7. Dispositif testeur de transformateur selon l'une quelconque des revendications précédentes,
dans lequel chaque source (21-23) des multiples sources (21-23) est configurée pour fonctionner comme une source de courant.

8. Dispositif testeur de transformateur selon l'une quelconque des revendications précédentes,
dans lequel chaque source (21-23) des multiples sources (21-23) peut être commandée de sorte qu'elle fonctionne sélectivement comme source de tension ou comme source de courant.

9. Dispositif testeur de transformateur selon l'une quelconque des revendications précédentes,
dans lequel le dispositif testeur de transformateur (10) comprend au moins un commutateur pouvant être commandé (49) afin de court-circuiter au moins l'une des phases du transformateur (50) au niveau d'un côté haute tension ou au niveau d'un côté basse tension.

10. Dispositif testeur de transformateur selon l'une quelconque des revendications précédentes,
dans lequel le dispositif testeur de transformateur (10) comprend au moins trois sources (21-23) mutuellement différentes.

11. Système, comprenant
un transformateur (50) avec de multiples phases et
un dispositif testeur de transformateur (10) selon l'une quelconque des revendications 1 à 10, qui est connecté de manière amovible aux multiples phases du transformateur (50) via les sorties (31-33) du dispositif testeur de transformateur (10).

12. Procédé de test d'un transformateur (50), qui présente de multiples phases, avec un dispositif testeur de transformateur (10),
dans lequel le dispositif testeur de transformateur (10) présente de multiples sorties (31-33) pour une connexion amovible du dispositif testeur de transformateur (10) avec les enroulements des multiples phases du transformateur (50),
dans lequel le procédé comprend les étapes consistant à :
commander de multiples sources (21-23) du dispositif testeur de transformateur (10) respectivement afin de générer un signal de test, et
commander une matrice de commutation (40) du dispositif testeur de transformateur (10) pour connecter sélectivement au moins une sortie des multiples sorties (31-33) du dispositif testeur de transformateur à une commutation en série ou une commutation en parallèle d'au moins deux sources des multiples sources (21-23) et pour délivrer en sortie au niveau de l'au moins une sortie un signal en tant que signal de test qui est généré par la commutation en série ou la commutation en parallèle des au moins deux sources.

13. Procédé selon la revendication 12,
qui est mis en oeuvre avec le dispositif testeur de transformateur (10) selon l'une quelconque des revendications 1 à 10.
